# EUROPÄISCHE PATENTSCHRIFT

(11) **EP 3 631 037 B1**
(45) Veröffentlichungstag und Bekanntmachung des Hinweises auf die Patenterteilung: **24.03.2021**
(21) Anmeldenummer: 18730975.2
(22) Anmeldetag: 29.05.2018
(51) Int. Cl.: C23C 4/16, C23C 4/134, C23C 16/513, C23C 16/04, B05B 13/06, B05B 7/22, C23C 16/453, C23C 16/455

(54) **PLASMA-BESCHICHTUNGSLANZE FÜR INNENBESCHICHTUNGEN**
PLASMA COATING LANCE FOR INTERNAL COATINGS
LANCE DE REVÊTEMENT PAR PLASMA POUR REVÊTEMENTS INTÉRIEURS

(30) Priorität: 29.05.2017 EP 17000902
(43) Veröffentlichungstag der Anmeldung: 08.04.2020
(73) Patentinhaber: Oerlikon Metco AG, Wohlen, 5610 Wohlen (CH)
(72) Erfinder: STOECKLI, Martin, 5623 Boswil (CH); MICHLA, Alexander, Paul, 5466 Kaiserstuhl (CH)
(74) Vertreter: Intellectual Property Services GmbH
(86) Internationale Anmeldenummer: PCT/EP2018/000276
(87) Internationale Veröffentlichungsnummer: WO 2018/219497

(56) Entgegenhaltungen:
- DE-A1-102013 007 737
- DE-A1-102014 010 665
- US-A- 4 970 364
- US-A1- 2008 185 366

## Beschreibung

Die Erfindung betrifft eine Beschichtungslanze für einen Plasmaprozess für Innenbeschichtungen von rotations-, asymmetrischen- oder Freiformflächen. Hierbei sind die Krümmungsrichtungen der Oberfläche in konkaver wie auch konvexer inbegriffen.

Bei dem Beschichtungsprozess wird über ein Lichtbogen ein Plasma 5 mit Hilfe einer Gasmischung generiert, in welches ein Pulver-Gasgemisch oder Draht injiziert wird. Durch die thermische Energie des Plasmas wird das zugeführte Material an- bzw. aufgeschmolzen und durch die kinetische Energie des Plasmas weg von der Beschichtungslanze in Richtung der zu beschichtenden Fläche umgelenkt. Hierbei ist eine Injektion aus allen Richtungen möglich.

Das an- bzw. aufgeschmolzene Material wird durch auf das Substrat beschleunigt und haftet dort durch Verklammerung an der Oberfläche. Die duktilen Materialtropfen verformen sich plastisch, und bilden mit der zuvor aktivierten Fläche (Aufrauprozess/Hinterschnitte) eine mechanische Verklammerung. Bei dem Erstarrungsprozess geben die Materialtropfen die zuvor durch das Plasma aufgenommene thermische Energie an das Substrat ab.

### Konventionell mechanische Fertigungsverfahren

Stand der Technik im Brennerbau sind die konventionellen Fertigungsmethoden, wie Drehen, Bohren, Fräsen, Giessen, und auch Löten sowie Kleben von Plasmalanzen bekannt. Hierbei wird das Design sehr oft durch die Fertigungsmethoden beeinträchtig. Gerade bei verlängerten und dünnen Innenbeschichtungswerkzeugen (Fig.: 1) kommen die konventionellen Fertigungsmethoden, wie Bohren an ihre physikalischen Belastungsgrenzen. Auch in der Entwicklungsphase wird eine sinnvolle Machbarkeit oft durch die Fertigungsverfahren erschwert.

In der Vergangenheit konnte eine lange mit reduziertem Durchmesser geforderte Lanze oft nur durch mühevolle Handarbeit und unzähligen Bearbeitungsschritten realisiert werden. Hierbei wurden stranggezogene Rohre gebogen und miteinander verlötet. Die Rohre hatten die Funktion die unterschiedlichen Medien in gas-, elektrischer und flüssiger Form voneinander zu trennen, isolieren und zum Plasmakopf zu befördern. Aufgrund der nichtlösbaren Verbindung "Löten" war eine Revision nur erschwert oder sehr aufwendig möglich. (Fig.: 2)

Stand der Technik wird in den Patentschriften US2008/185366 A1, US4970364 A und DE102013007737 A1 offenbart.

Es zeigen die Figuren:

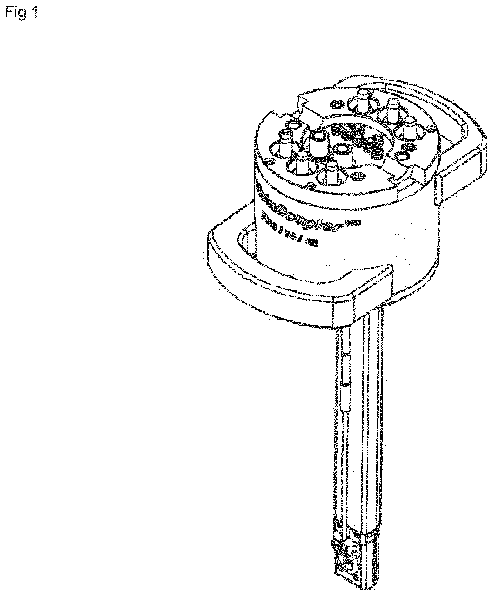

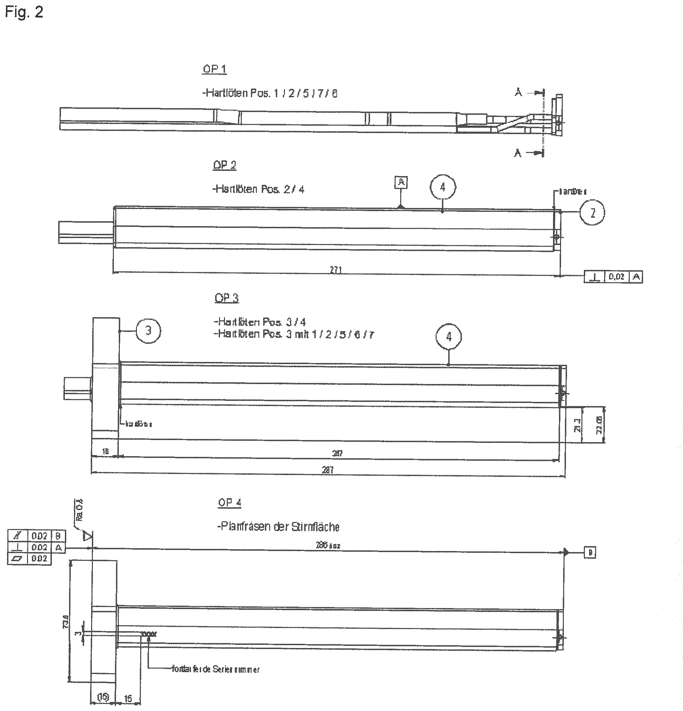

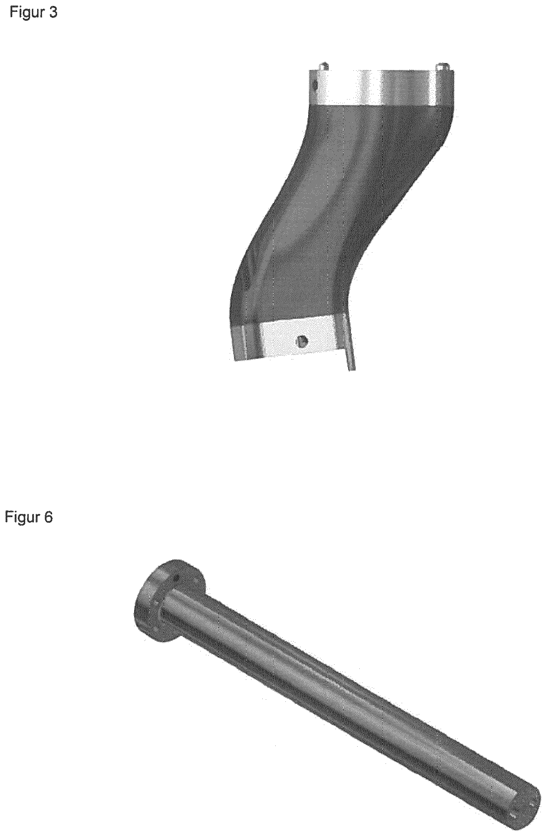

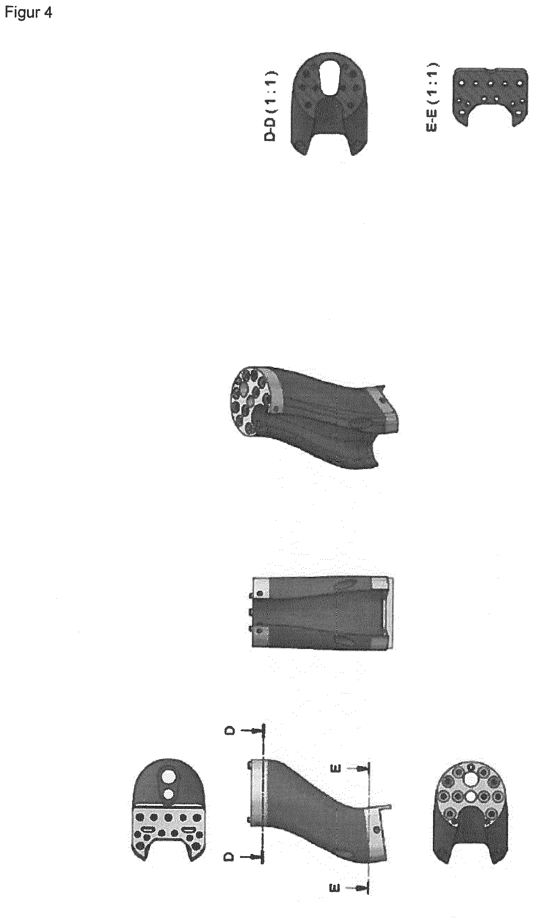

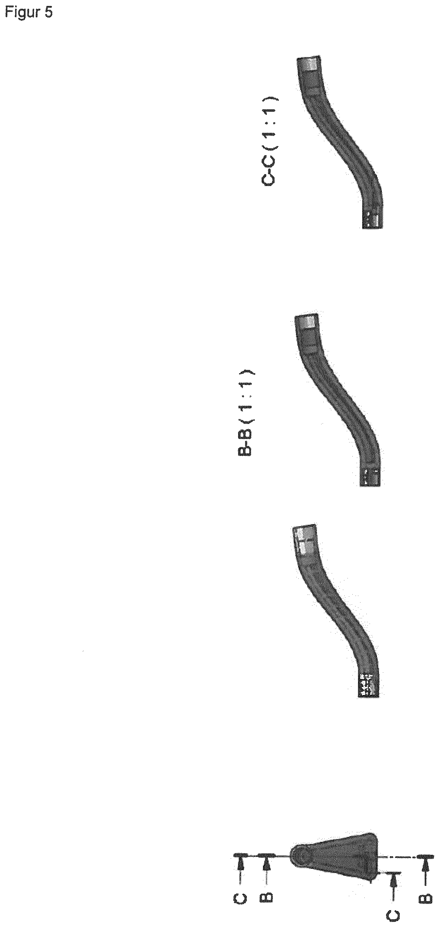

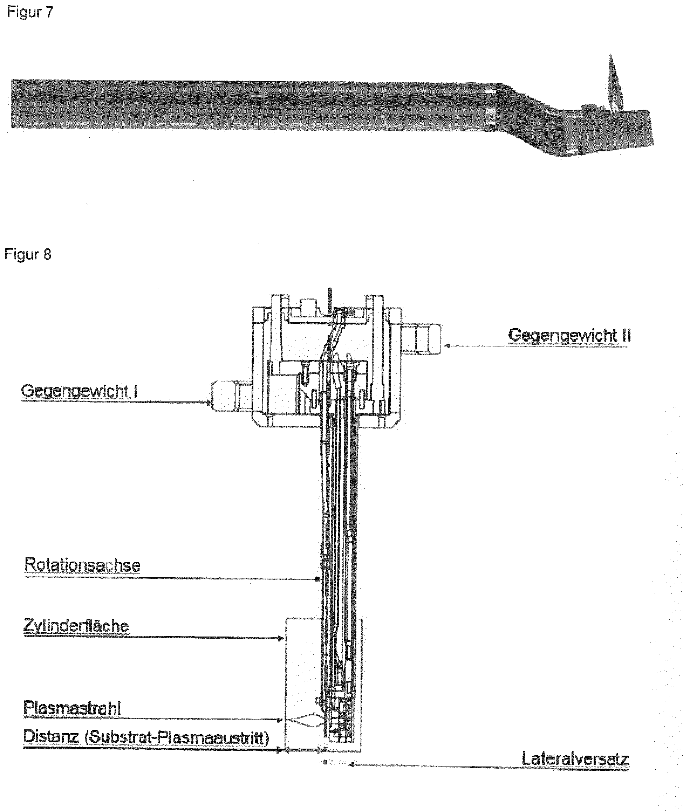

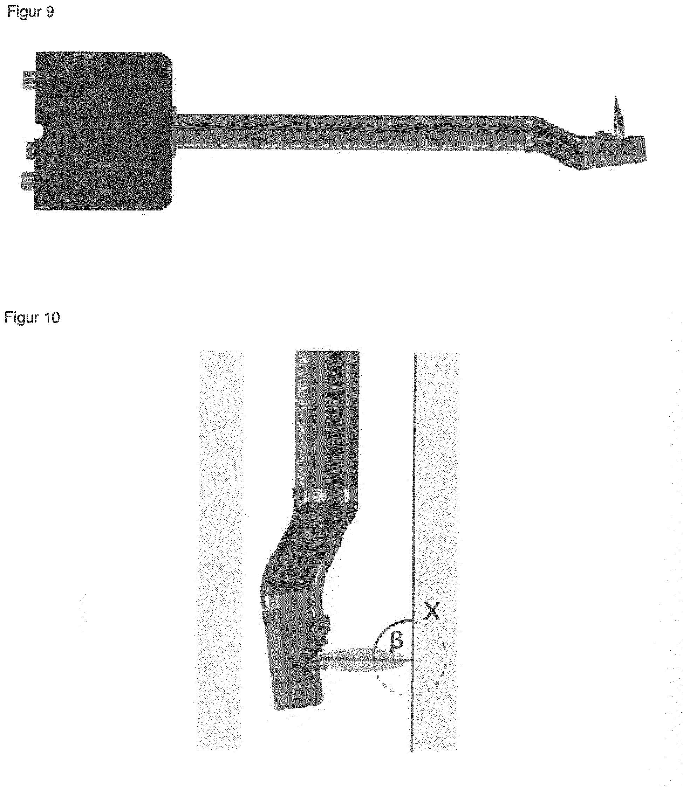

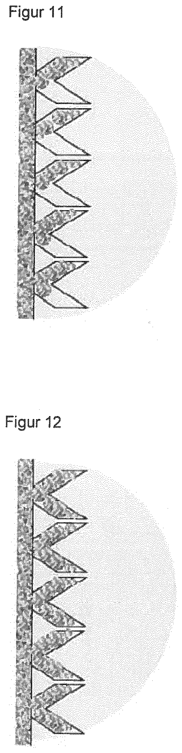

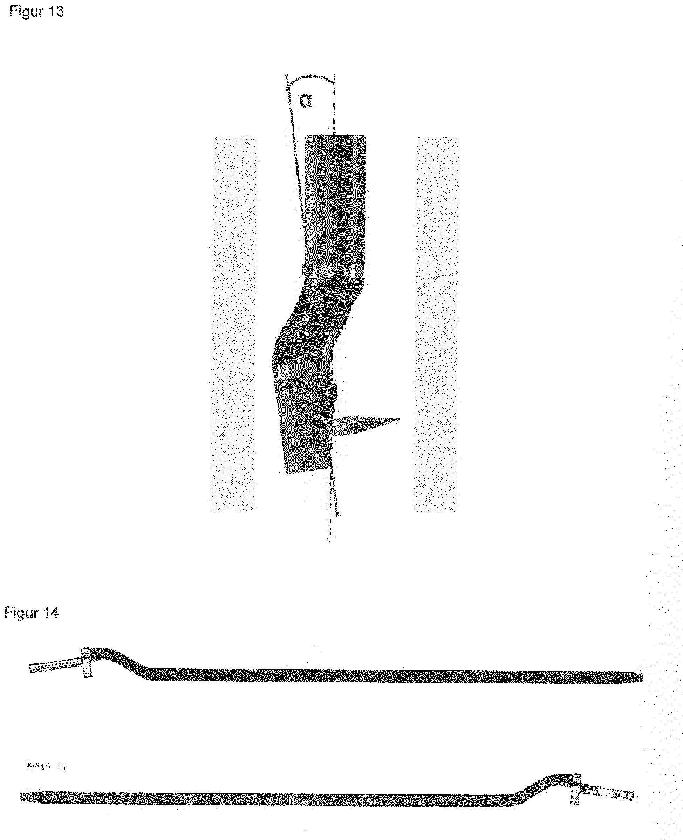

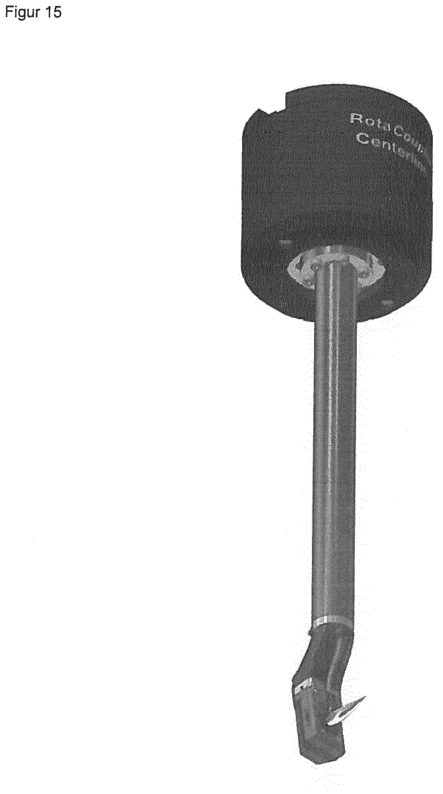

Fig 1: Beschichtungslanze
Fig.: 2 Manuelle Lötvertigungszeichnung
Fig.: 3 Additiv gefertigter Plasmakopf aus einer Kupferlegierung
Fig.: 4 Additive gefertigter Plasmakopf im Detail (innen liegend geschwungene Bohrungen)
Fig.: 5 Additive gefertigter Minuspol aus Kupferlegierung
Fig.: 6 Tieflochgebohrte Lanze
Fig.: 7 Heirat Plasmakopf, Minuspol und Lanze
Fig.: 8 Lateralversatz um Distanz zur Zylinderwand beizubehalten
Fig.: 9 Lateralversatz nur am Brennerkopf
Fig.: 10 Beschichtung
Fig.: 11 Unzureichende Profilfüllung durch nicht rechtwinkliges Auftreffen der Partikel (Schatteneffekt)
Fig.: 12 Ausreichend gefüllte Profilfüllung der Hinterschnitte
Fig.: 13 Winkelkorrektur
Fig.: 14 Gasgekühlte Anode (Rohrprofil Kupferlegierung, Minuspol additiv gefertigt, Isolation (schwarz), Isolation Anode - Kathode (weiss))
Fig.: 15 F210 RotaCoupler™ Centerline

Die Erfindung betrifft eine Beschichtungslanze für einen Plasmaprozess und ein Verfahren zur Herstellung einer Beschichtungslanze gemäß den angehängten Ansprüchen 1-6.

### Additives Fertigungsverfahren und Tieflochbohrung

Durch das Fertigungsverfahren des Additive Manufacturing entstehen neue Möglichkeiten in der konstruktiven Designphase. Jedwede Form kann erstellt und gefertigt werden. Durch diesen Vorteil lassen sich unabhängig von konventionellen Methoden sehr kompakte Bauteile mit Freiformflächen fertigen. (Fig.:3). Gerade Bohrungen, die bislang in runder Ausführung erstellt werden mussten, oder mühevoll mit teuren Fertigungswerkzeugen herauserodiert werden mussten, und nur in gerader Ausführung möglich waren, können in der additiven Fertigung jede geometrische Ausführung haben. Ein weiterer Vorteil ist die "Bohrung um die Ecke", wodurch Bohrungen in Kurvenbahnen aneinander vorbei oder sich in unterschiedlichen Eben kreuzen aber nicht schneidend ausgeführt werden können. Durch diese Vorteile können optimierte Leitungsführungen und optimale Materialausnutzung gewährleistet werden, wodurch eine Miniaturisierung der Brennerlanze gewährleistet werden kann. (Fig.: 4)

Es wäre technisch möglich die gesamte Lanze durch das additive Verfahren zu fertigen, allerdings ist das bis heute unwirtschaftlich und aktuell nicht notwendig. Aus diesem Grund wird hier lediglich der Plasmakopf (Fig.: 4) und der Minuspol (Fig.: 5) am Plasmakopf durch das additive Fertigen erstellt. In Verbindung mit der additiven Fertigung kommt das Fertigungsverfahren des "Tieflochbohrens" zum Einsatz, um den Schaft der Lanze auszubilden. Dieses Verfahren ist in Verbindung mit dem Bohrungsdurchmesser längenlimitiert. Um das aufzufangen, können mehrere tieflochgebohrte Schäfte (Fig.: 6) aneinander gereiht und verschraubt werden. Theoretisch gäbe es dadurch keine Limitierung der Lanzenlänge. Um die Beschichtungslanze fertigzustellen werden der additiv gefertigte Plasmakopf Komponenten und die tieflochgebohrte Lanze miteinander verschraubt. (Fig.: 7)

### Plasmalanze und RotaPlasma® HS1

In der Vergangenheit wurde die Beschichtungslanze durch die zuvor beschriebenen Fertigungsverfahren hergestellt. Bei dem RotaPlasma® Prozess handelt es sich um einen rotativen Beschichtungsprozess. Eine Drehdurchführung befördert die Medien vom stationären Anschluss zu einer endlos rotierenden Welle. An dieses Wellenende wird eine Plasmalanze adaptiert, wodurch eine Innenbeschichtung von zum Beispiel Zylinderlaufflächen eins Motorblocks beschichtet werden können.

Bei der Beschichtung eines Substrates müssen eine Oberflächengeschwindigkeit und eine gewisse Distanz eingehalten werden. Bei der Rotation der Lanze einem Vorschub in Bohrungsachsrichtung und dem zuvor beschriebenen Schmelzvorgang entsteht so ein Schichtaufbau an der Substratoberfläche. Hierbei bleibt die Distanz zwischen Plasmaaustritt und Substratoberfläche konstant. Da die Achse der drehenden Welle des RotaPlasma® koaxial zur Rotationsachse der Bohrung angeordnet ist, muss der Plasmakopf bei einer grösseren zu beschichtenden Bohrung lateral zur Bohrungsachse ausgelenkt werden. Bei früheren Ausführungen wurde die gesamte Plasmalanze lateral ausgelenkt, wodurch bei der erhöhten Rotationsgeschwindigkeit starke Fliehkräfte erzeugt wurden. Diese Fliehkräfte erzeugten ungewollte Schwingungen und Belastungen auf das Antriebssystem aber auch auf die Schichtqualität am Substrat. Um den Fliehkräften entgegenzuwirken, wurden Gegengewichte angebracht, um die Unwucht des lateralen Versatzes dynamisch Auszuwuchten. Da, wie zuvor beschrieben die gesamte Lanze lateral verschoben wurde, wurde eine enorme Unwucht hervorgerufen. (Fig.: 8)

Aufgrund der zuvor beschriebenen Fertigungsmethoden der neuen Beschichtungslanze, wird lediglich der Plasmakopf lateral ausgelenkt. Die Lanze bleibt koaxial zur rotierenden Welle des RotaPlasma® angeordnet. Durch diese Methode wird nur ein kleiner Massenschwerpunkt der Beschichtungslanze aus der Drehachse lateral versetzt, wodurch eine signifikante Reduzierung der Fliehkraft und der damit resultierenden dynamischen Unwucht erzeugt wird. Als Folge dessen, ist eine Reduzierung der Auswuchtgewichte gewährleistet. So ist nahezu jede Distanz zwischen Plasmaaustritt und Substratoberfläche möglich. (Fig.: 9) Ein weiterer Vorteil der neuen Fertigungsverfahren ist gleichbleibende Massenpunkte aller Komponenten. Nachdem eine Lanze gefertigt wurde, wird die Unwucht gemessen, und die Gegengewichte hergestellt. Jede weitere Plasmalanze mit gleichbleibendem Lateralversatz kann mit den zuvor definierten Gewichten ausgewuchtet werden. Im Vergleich zur konventionellen Herstellung (Handarbeit) war jede Lanze ein Einzelstück, und war nur sehr erschwert und ungenau automatisiert Auswuchtbar. D.h. Lanze eins wurde mit lateral Versatz x gefertigt, anschliessend wurden auf einer Wuchtmaschine die Unwucht ermittelt und die Gegengewichte definiert um diese zu Fertigen und an der Lanze zu befestigen. Wurde später Lanze zwei gefertigt mit demselben lateralen Versatz wie Lanze eins, so wies Lanze zwei nicht dieselbe Unwucht auf. Dies erschwerte eine automatisierte Kleinserienfertigung der Plasmalanzen. Die Ungenauigkeit resultiert aus der Toleranzsummierung der Handarbeit in den vorgelagerten Prozessen. Im Gegensatz hierzu sind die neuen Fertigungsverfahren um ein vielfaches präziser und gleichbleibend.

### Füllgrad Hinterschnitt

Um eine Haftung zwischen aufgeschmolzenen Partikeln und Substrat bei der Beschichtung (Fig.: 10) zu erreichen, muss die Oberfläche des Werkstückes vorbehandelt werden. Hierbei bekannt sind mechanische und thermische Verfahren. Entscheidend bei allen Verfahren ist ein generieren von Hinterschnitten auf der Werkstückoberfläche, um ein Verklammerung zwischen Substrat und aufgeschmolzenen Partikeln zu erreichen. Thermische Verfahren sind hierbei das Laseraktivieren. Dem gegenüber stehen die mechanischen Verfahren der Aktivierung: Korundstrahlen, pulsierendem Wasserstahl und dem mechanischem Schneidwerkzeug. Durch das Korund- sowie dem pulsierendem Wasserstahlaktivieren resultiert eine chaotisch ungeordnet stochastische Hinterschnittgeometrie. Im Gegensatz hierzu erzeugt die Schneidplatten beim Schneidwerkzeug durch eine Rotation und dem Vorschub eine spiralförmige Kontur. Die Schneidgeometrie ist ähnlich einem Schwalbenschwanz ausgeführt, wodurch geordnete Hinterschnitte erzeugt werden. Anders als bei den zuvor beschriebenen Verfahren der Aktivierung bedingt diese Ausführung ein nahezu rechtwinkliges Auftreffen der aufgeschmolzenen Partikel, um ein unvollständig gefüllte Profilfüllung (Fig.: 11) zu verhindern und eine vollständige Füllung des Schwalbenschwanzgrundes (Fig.: 12) zu erreichen. Nur dann kann eine ausreichende Verklammerung entstehen.

In dem zuvor beschriebenen neuen Fertigungsverfahren, sind die Geometrien des Plasmakopfes frei wählbar. Die Richtung Bewegungsrichtung der aufgeschmolzenen Partikel wird durch den Plasmastrahl beeinflusst und umgelenkt. Gerade, bei einer Injektion von oben, wird der Plasmastrahl allerdings durch die mechanische Energie des Pulver-Gas-Gemisches nach unten abgelenkt. Gerade bei erhöhten Förderraten ist dies sehr auffallend. Um diesem Phänomen entgegenzuwirken und die Flugbahn der Partikel und den damit verbunden Auftreffwinkel auf 90° zur Substratoberfläche zu korrigieren, muss der Winkel des Plasmaaustritts korrigiert werden. (Fig.: 13) Winkelkorrektur
- α =0°
   Lanze und Plasmakopf vertikal ausgerichtet
- -90° < α < 0°
   Lanze Vertikal, Plasmakopf α < 0° angestellt

### Strombelastung Minuspol

Um ein Plasma zu erzeugen ist neben einem Gasgemisch das Erzeugen eines Lichtbogens erforderlich. Hierzu werden die Kathode und Anode elektrisch zueinander isoliert bis zum Plasmakopf geführt. Durch ein Zündfunke im kV Bereich springt ein Lichtbogen von der Kathode zur Anode. Dadurch werden das Gasgemisch und der Lichtbogen in ein Plasma überführt. Dabei reduziert sich die Spannung schlagartig und analog dazu springt die Stromstärke in die Höhe. Dadurch entsteht durch die Einleitung der Stromstärke im 300 - 600 A Bereich und dem resultierendem Übergangswiderstand eine enorme thermische Strombelastung der Kathode und Anode. In älteren Ausführungen der Plasmalanzen für Innenbeschichtungen waren die Stromstärke und damit die Plasmaleistung limitiert. Die Flächenbelastung der kleinen Plasmalanze im speziellen der Kathode stellte hierbei eine erhebliche Schwachstelle dar. Bei der Anode war dieses Phänomen weniger kritisch, da diese Wassergekühlt ausgeführt werden konnte. Um die Strombelastung der Kathodenschiene zu reduzieren, ist die Kathode (Minuspol) aktiv gekühlt. Dies geschieht durch das für den Plasmaprozess notwendigen Gasgemisches. Das Plasmagasgemisch wird hierbei über ein Rohrprofil zur Kathode geführt, dort mit dem additiv gefertigten Minuspol verbunden. (Fig.: 14)

Dabei ist der Minuspol konstruktiv so ausgeführt, dass innenliegend eine Eingangsbohrung zu zwei Kühladern im inneren der Kathode verlaufen. Dadurch wird die Kathode aktiv durch das Plasmagas gekühlt und die Strombelastung signifikant herabgesetzt.

Es wurde eine Beschichtungslanze für einen Plasmaprozess offenbart
wobei die Lanze einen Plasmaschaft, einen Plasmahals und einen Plasmakopf umfasst wobei der Plasmaschaft einen Längskanal umfasst welcher sich in einer axialen Richtung entlang einer Achse von einem ersten Schaftende bis zu einem zweiten Schaftende erstreckt
wobei der Plasmahals einen Schaftansatz und einen Kopfansatz und zumindest einen Halskanal umfasst der vom Schaftansatz zum Kopfansatz verläuft und der Schaftansatz am zweiten Schaftende angeordnet ist dergestalt, dass der Längskanal in den zumindest einen Halskanal einmündet
wobei der Plasmakopf einen Halsansatz, eine Plasmaöffnung und zumindest einen Kopfkanal umfasst der vom Halsansatz bis zur Plasmaöffnung verläuft und der Halsansatz des Plasmakopfes am Kopfansatz des Plasmahalses angeordnet ist dergestallt, dass der zumindest eine Halskanal in den Kopfkanal einmündet. Der Verlauf des Plasmakanals weicht derart von der Achse ab dass der Halskanal bzgl. der Achse nicht zentriert, d.h. gegenüber der Achse versetzt in den Kopfkanal einmündet.

Der Plasmahals ist vorzugsweise lösbar am zweiten Schaftende fixiert ist. Besonders bevorzugt ist der Plasmakopf ebenfalls lösbar am Plasmahals fixiert.

Der Halskanal weisst bevorzugt zumindest eine Krümmung auf besonders bevorzugt zumindest zwei Krümmungen mit unterschiedlichem Vorzeichen.

Die durch den Rand der Plasmaöffnung definierte Ebene kann mit Vorteil gegenüber der Achse um einen Winkel α < 0° angestellt sein

Es wurde ein Verfahren zur Herstellung eine Beschichtungslanze wie oben beschrieben offenbart, wobei zumindest der Plasmahals, vorzugsweise auch der Plasmakopf mittels eines additiven Herstellungsverfahrens, bevorzugt durch schichtweisen Aufbau hergestellt wird.

Der Längskanal im Plasmaschaft kann zumindest teilsweise vorzugsweise vollständig mittels tieflochbohren hergestellt werden.

## Patentansprüche

1. Beschichtungslanze für einen Plasmaprozess,
wobei die Lanze einen Plasmaschaft, einen Plasmahals und einen Plasmakopf umfasst wobei der Plasmaschaft einen Längskanal umfasst welcher sich in einer axialen Richtung entlang einer Achse von einem ersten Schaftende bis zu einem zweiten Schaftende erstreckt;
wobei der Plasmahals einen Schaftansatz und einen Kopfansatz und zumindest einen Halskanal umfasst der vom Schaftansatz zum Kopfansatz verläuft und der Schaftansatz am zweiten Schaftende angeordnet ist dergestalt, dass der Längskanal in den zumindest einen Halskanal einmündet;
wobei der Plasmakopf einen Halsansatz, eine Plasmaöffnung, und zumindest einen Kopfkanal umfasst der vom Halsansatz bis zur Plasmaöffnung verläuft, und der Halsansatz des Plasmakopfes am Kopfansatz des Plasmahalses angeordnet ist dergestallt, dass der zumindest eine Halskanal in den Kopfkanal einmündet, **dadurch gekennzeichnet, dass**
der Verlauf des Plasmakanals derart von der Achse abweicht, dass der Halskanal bzgl. der Achse nicht zentriert, d.h. gegenüber der Achse versetzt in den Kopfkanal einmündet

2. Beschichtungslanze nach Anspruch 1, **dadurch gekennzeichnet, dass** der Plasmahals lösbar am zweiten Schaftende fixiert ist.

3. Beschichtungslanze nach einem der vorangehenden Ansprüche, **dadurch gekennzeichnet, dass** der Halskanal zumindest eine Krümmung aufweist und vorzugsweise zumindest zwei Krümmungen mit unterschiedlichem Vorzeichen aufweiset

4. Beschichtungslanze nach einem der vorangehenden Ansprüche, **dadurch gekennzeichnet, dass** die durch den Rand der Plasmaöffnung definierte Ebene gegenüber der Achse um einen Winkel α < 0° angestellt ist.

5. Verfahren zur Herstellung einer Beschichtungslanze gemäss einem der vorangehenden Ansprüche, **dadurch gekennzeichnet, dass** zumindest der Plasmahals, vorzugsweise auch der Plasmakopf mittels eines additiven Herstellungsverfahrens, bevorzugt durch schichtweisen Aufbau hergestellt wird.

6. Verfahren nach Anspruch 5, **dadurch gekennzeichnet, dass** der Längskanal im Plasmaschaft zumindest teilweise mittels Tieflochbohren hergestellt wird.

## Claims

1. A coating lance for a plasma process,
the lance comprising a plasma shaft, a plasma neck and a plasma head, the plasma shaft comprising a longitudinal channel, which extends in an axial direction along an axis from a first shaft end to a second shaft end,
the plasma neck comprising a shaft attachment and a head attachment and at least one neck channel, which extends from the shaft attachment to the head attachment and the shaft attachment is arranged at the second shaft end in such a way that the longitudinal channel opens into the at least one neck channel,
the plasma head comprising a neck attachment, a plasma opening and at least one head channel, which extends from the neck attachment to the plasma opening and the neck attachment of the plasma head is arranged at the head attachment of the plasma neck in such a way that the at least one neck channel opens into the head channel,
**characterized in that** the course of the plasma channel deviates from the axis in such a way that the neck channel does not open into the head channel centered with respect to the axis, i.e. offset with respect to the axis.

2. A coating lance according to claim 1, **characterized in that** the plasma neck is detachably fixed at the second shaft end.

3. A coating lance according to anyone of the preceding claims, **characterized in that** the neck channel has at least one curvature and preferably has at least two curvatures with opposite signs.

4. A coating lance according to anyone of the preceding claims, **characterized in that** the plane defined by the edge of the plasma opening is inclined with respect to the axis by an angle α < 0°.

5. A process for manufacturing a coating lance according to anyone of the preceding claims, **characterized in that** at least the plasma neck, preferably also the plasma head, is manufactured by means of an additive manufacturing process, preferably by a structure in layers.

6. A process according to claim 5, **characterized in that** the longitudinal channel in the plasma shaft is manufactured at least partially by means of deep-hole drilling.

## Revendications

1. Une lance de revêtement pour un procédé au plasma,
dans laquelle la lance comprend une tige de plasma, un col de plasma et une tête de plasma, dans laquelle la tige de plasma comprend un canal longitudinal s'étendant dans une direction axiale le long d'un axe d'une première extrémité de tige à une seconde extrémité de tige ;
dans laquelle le col de plasma comprend une extension de tige et une extension de tête et au moins un canal de col s'étendant de l'extension de tige à l'extension de tête, et l'extension de tige est disposée à la deuxième extrémité de tige de telle sorte que le canal longitudinal s'ouvre dans le au moins un canal de col;
dans laquelle la tête de plasma comprend une extension de col, un orifice de plasma et au moins un canal de tête s'étendant de l'extension de col à l'orifice de plasma, et l'extension de col de la tête de plasma est disposée à l'extension de tête du col de plasma de telle sorte que le au moins un canal de col s'ouvre dans le canal de tête,
**caractérisé en ce que** le cours du canal de plasma dévie de l'axe de telle manière que le canal de col s'ouvre dans le canal de tête non centré par rapport à l'axe, c'est-à-dire décalé par rapport à l'axe.

2. La lance de revêtement selon la revendication 1, **caractérisée en ce que** le col de plasma est fixé de manière amovible à la deuxième extrémité de tige.

3. La lance de revêtement selon l'une des revendications précédentes, **caractérisée en ce que** le canal de col présente au moins une courbure et présente de préférence au moins deux courbures ayant des signes algébriques différents.

4. La lance de revêtement selon l'une des revendications précédentes, **caractérisée en ce que** le plan défini par le bord de l'orifice de plasma est incliné par rapport à l'axe d'un angle α < 0°.

5. Un procédé de fabrication d'une lance de revêtement selon l'une des revendications précédentes, **caractérisé en ce qu'**au moins le col de plasma, de préférence également la tête de plasma, est produit au moyen d'un procédé de fabrication additif, de préférence par construction couche par couche.

6. Le procédé selon la revendication 5, **caractérisé en ce que** le canal longitudinal dans la tige de plasma est produit au moins partiellement au moyen d'un forage profond.
